# EUROPEAN PATENT APPLICATION

(11) **EP 4 092 437 A1**
(43) Date of publication of application: **23.11.2022**
(21) Application number: 21174351.3
(22) Date of filing: 18.05.2021
(51) Int. Cl.: G01R 33/36

(54) **RF TRANSMIT ARRAY WITH DYNAMIC IMPEDANCE CONTROL**

(71) Applicant: Koninklijke Philips N.V., 5656 AG Eindhoven (NL)
(72) Inventor: DUENSING, George Randall, 5656 AE Eindhoven (NL)
(74) Representative: Philips Intellectual Property & Standards

(57) **Abstract**

A radio frequency (RF) transmit array (1) for magnetic resonance imaging, wherein the RF transmit array (2) being arranged to generate an RF transmit field, includes a least one antenna element (2), wherein the antenna element (2) comprising a conductive loop (3) and the antenna element (2) is adapted to be driven by a radio frequency (RF) driving field. Each antenna element (2) comprises an impedance control unit (4) for controlling the impedance of the antenna element (2) and at least one pickup loop (5) for sampling RF pulses to control a transmit/receive switching of the antenna element (2) and allowing impedance selection for each antenna element (2). The RF transmit array (1) is arranged to generate a spatially distributed RF transmit field for RF spatial encoding of magnetic resonance signals by dynamically controlling the impedance of the antenna element (2).

## Description

### FIELD OF THE INVENTION

The invention relates to magnetic resonance imaging, in particular to a radio frequency (RF) transmit array for magnetic resonance imaging. The invention further relates to an MR imaging system, a method of operating a magnetic resonance imaging system for acquiring magnetic resonance data, a computer program product and a radio-frequency antenna configured for acquiring magnetic resonance data.

### BACKGROUND OF THE INVENTION

A magnetic field is used in magnetic resonance imaging (MRI) to align the nuclear spins of atoms as part of the procedure for producing images within the body of a patient.

This magnetic field is referred to as the B₀ field. During an MRI scan, Radio Frequency (RF)
pulses generated by a transmitter or amplifier and an antenna cause perturbations to the local
magnetic field and can be used to manipulate the orientation of the nuclear spins relative to
the B₀ field. RF signals emitted by the nuclear spins are detected by a receiver coil, and these RF signals are used to construct the MRI images.

The standard RF system in MRI is a transmit body coil and local receive coils though local transmit coils are well known and a few are commercially available. In principle, transmit/receive coils have advantages because they do not produce excitation outside of the intended ROI and require much less power and allow higher peak SAR levels in some cases (e.g. extremities). An additional advantage is that baluns to block large voltages on the cable are not needed. Historically, one manufacturer's MR system was designed for cost, that exclusively used local transmit and receive coils, but it was not highly commercially successful. Additional research efforts have utilized on-board power amplifiers for each coil element.

Traditional transmit coils require high power cables which are unwieldy and heavy. Additionally, there is a serious safety problem if a transmit/receive coil is accidentally left in the MR system without being plugged in and recognized as such because high currents can be induced in the coil elements (which are not detunable) or on the cables, which do not require baluns for standard use.

In the document WO2013/008116 a Magnetic Resonance Imaging (MRI) system including a radio-frequency transmitter with multiple transmit channels is disclosed. The MRI system includes an impedance matching network for matching the radio-frequency transmitter to a remotely adjustable radio-frequency antenna with multiple antenna elements. The MRI system includes a processor for controlling the MRI system. The execution of the instructions by the processor causes it to measure a set of radio-frequency properties of the radio-frequency antenna, calculate a matching network command using the set of radio-frequency properties and a radio frequency model, and adjust the impedance matching network by sending the matching network command to the impedance matching network, thereby enabling automatic remote impedance matching.

### SUMMARY OF THE INVENTION

It is an object of the invention to provide a radio frequency (RF) transmit array for magnetic resonance imaging with dynamic impedance control for partial spatial encoding of the magnetic resonance signal to simplify and improve the generation of a B1+ RF transmit field enabling an MRI scanner at extremely low bill of materials costs.

According to the invention, this object is addressed by the subject matter of the independent claims. Preferred embodiments of the invention are described in the sub claims.

Therefore, according to the invention, this object is achieved by a radio frequency (RF) transmit array for magnetic resonance imaging, the RF transmit array being arranged to generate an RF transmit field, the RF transmit array comprising:
- a least one antenna element, the antenna element comprising a conductive loop, wherein the antenna element is adapted to be driven by a radio frequency (RF) driving field,
- each antenna element comprising an impedance control unit for controlling the impedance of the antenna element,
- each antenna element further comprising at least one pick-up loop for sampling RF pulses to control a transmit/receive switching of the antenna element and allowing impedance selection for each antenna element,
- wherein the RF transmit array is arranged to generate a spatially distributed RF transmit field for RF spatial encoding of magnetic resonance signals by dynamically controling the impedance of the antenna element.

The main idea of the invention is an RF transmit array with dynamic RF field sensing and impedance control built into the antenna element of the RF transmit array for generating a spatially distributed RF transmit field for RF spatial encoding of magnetic resonance signals. Pick-up loops sample the RF pulses to control TR switching and allow impedance selection for each antenna element. This enables optimized local excitation as well as transmit compressed SENSE and MR Barcoding or TRASE (RF encoding). Modern techniques, such as AI, can also help to improve the overall uniformity of the images beyond what is possible by discrete control of currents in the constituent coil elements. A system based around RF encoding eliminates gradients which eliminates a considerable portion of the bill of materials costs, plus allows a much smaller magnet for the same bore size thus further reducing costs. The bill of material costs for the RF transmit system can also be reduced as a result. This enables an MRI scanner at extremely low bill of materials cost.

The idea of dynamic impedance control of loop currents, the driving RF fields e.g. from the low power body coil can be square pulses which greatly simplifies the RF amplifier requirements.

According to an advantageous embodiment of the invention the impedance control unit is further configured to adjust the impedance of the antenna element on the basis of the driving RF field and/or based on instructions contained in a control unit and/or instructions communicated to the control unit from an external source.

According to another advantageous embodiment of the invention each antenna element comprises an energy harvesting unit, wherein the energy harvesting unit is configured for transfering excess electrical current in the conducive loop of the antenna element to an electric energy storage device. An advantage is that the RF power that can be captured in the conversion from square pulses to the pulse shapes of interest can be used via energy harvesting to run the electronics of the preamplifiers, TR switches, receivers and communication mechanisms. The energy storage ensures that the conductive loop does not overheat when highly resonant and the energy in the excess current may be applied to on board control electronics of the antenna elements.

Preferably the energy harvesting unit is further configured to control an amplitude of an RF current in the conductive loop of the antenna element. The use of energy harvesting advantageously allows control of the current amplitude via a resistance that is virtual and associated with the energy storage device instead of dissipation.

In an embodiment the electric energy storage device is a battery, an accumulator or a capacitor.

In another embodiment of the invention the antenna element comprises a control unit for controlling the transmit/receive switching of the antenna element. The antenna elements may also be operated in receive mode.

Preferably the control unit comprises a wireless data communication system. By means of the wireless data communication system a fully wireless versions of a RF transmit array can be realized eliminating any hazards associated with cables.

In another embodiment the conductive loop of the antenna element comprises a circuit for changing the capacitance in the conductive loop for controlling the phase of the RF current in the conductive loop. The phase can easily be controlled by a change in capacitance in the conductive loop of the antenna element.

In another aspect of the invention, the object is achieved by a magnetic resonance imaging system for acquiring magnetic resonance data, wherein the magnetic resonance imaging system comprises:
an RF transmit array as described above.
In an embodiment the MR imaging system comprises a body coil for generating the RF driving field.

In another aspect of the invention, the object is achieved by a method for operating a magnetic resonance imaging system for acquiring
magnetic resonance data, wherein the method comprises the following steps:
- providing an RF transmit array acoording to one of the claims 1 to 8,
- sampling a waveform of the RF driving field by the pick-up loop,
- adjusting the impedance of the antenna element,
- generating a spatially distributed RF transmit field for inducing RF spatial encoding in magnetic resonnace signals.

In an embodiment the step of adjusting the impedance of the antenna element comprises the step of adjusting the phase and amplitude of the RF current in the conductive loop of the antenna element.

In another embodiment of the invention each antenna element comprises an energy harvesting unit and the method comprises the following additional steps:
- transfering excess electrical current in the conducive loop of the antenna element to an electric energy storage device,
- providing the energy stored in the electrical storage device for power supply of electronic components of the RF transmit array.

In another aspect of the invention, the object is achieved by a computer program product comprising machine executable instructions, wherein the machine executable instructions are for execution by a processor controlling a magnetic resonance imaging system for acquiring magnetic resonance data, according to the method as described above.

In a still further aspect of the invention, the object is achieved by a radio-frequency antenna configured for acquiring magnetic resonance data, wherein the radio-frequency antenna comprises:
- a least one antenna element, the antenna element comprising a conductive loop, wherein the antenna element is adapted to be driven by a radio frequency (RF) driving field,
- each antenna element comprising an impedance control unit for controlling the impedance of the antenna element, wherein the impedance control unit is configured to adjust the impedance of the antenna element on the basis of a waveform of the RF driving field,
- each antenna element further comprising at least one pick-up loop wherein the pick-up loop is configured to sample RF pulses to control TR switching and allowing impedance selection for each antenna element for generating a spatially distributed RF transmit field for RF spatial encoding of magnetic resonance signals by dynamically controling the impedance of the antenna element.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts an RF transmit array of a magnetic resonance imaging system according to an embodiment of the invention,
Fig. 2 shows a flowchart of a method for operating a magnetic resonance imaging system for acquiring magnetic resonance data according to an embodiment of the invention.

### DETAILED DESCRIPTION OF EMBODIMENTS

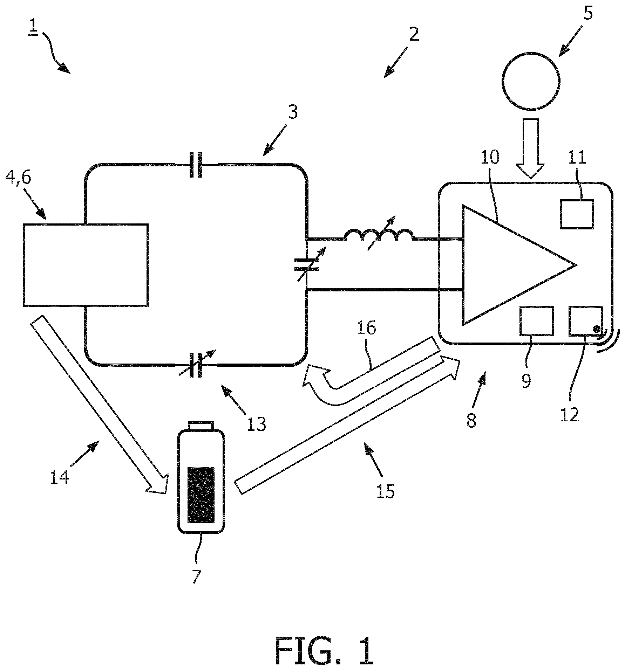

Fig. 1 schematically depicts an RF transmit array 1 of a magnetic resonance imaging system according to an embodiment of the invention. The RF transmit array 1 comprises at least one antenna element 2, wherein the antenna element 2 comprises a conductive loop 3. The antenna element 2 is adapted to be driven by a radio frequency (RF) driving field. The antenna element 2 shown in Fig. 1 comprises further an impedance control unit 4 for controlling the impedance of the antenna element 2. The RF transmit array 1 is arranged to generate a spatially distributed RF transmit field for RF spatial encoding of magnetic resonance signals by dynamically controling the impedance of the antenna element 2. The impedance is dynamic on the scale necessary to produce a prescribed waveform required for the encoding desired.

The impedance control unit 4 is further configured to adjust the impedance of the antenna element 2 on the basis of the driving RF field and/or based on instructions contained in a control unit 8 and/or communicated to the control unit 8 from an external source. In a case where the RF driving field is a square pulse, meaning constant in amplitude and phase, but the desired pulse shape of field (and current) in a given element is a sinc function as defined by an internal memory, or as directed from an external controlling source, the impedance changes produce this sinc function of current given the constant RF field (and induced voltage). The resultant field is the sum of the RF driving field and the secondary field, but because the local antenna element 2 is very close and high Q, it's field dominates, but if high accuracy is desired, the sum of the fields is the target.

Each antenna element 2 comprises a pick-up loop 5 for sampling RF pulses to control a transmit/receive switching of the antenna element 2 and allowing impedance selection for each antenna element 2. In an embodiment of the invention the pick-up loops 5 are passive coils that are designed to pick up the RF fields. In a further embodiment the pick-up loops 5 can have built in a mechanisms to control the currents, plus fail-safe fuses. In an embodiment of the invention several pick-up loops 5 can be provided. One pick-up loop 5 can receive the transmitted field from the body coil, and another pick-up loop 5 can be oriented to just pick up the field (or current) being generated in the local coil. This can provide a constant feedback mechanism with the impedance control to ensure the resultant pulse shape is as required.

An advantage is that the RF power that can be captured in the conversion from square pulses to the pulse shapes of interest can be used via energy harvesting to run the electronics of the preamplifiers 10, TR switches, receivers 9 and communication devices. The energy storage ensures that the conductive loop 3 does not overheat when highly resonant and the energy in the excess current may be applied to a control unit 8 of the antenna element 2. In an embodiment of the invention each antenna element 2 comprises an energy harvesting unit 6, wherein the energy harvesting unit 6 is configured for transfering excess electrical current in the conductive loop 3 of the antenna element to an electric energy storage device 7. Fig. 1 shows the current path 14 from the energy harvesting unit 6 to the electric energy storage device 7 and the current path 15 from the electric energy storage device 14 to the electronics of the RF transmit array 1.

The phase of the current in the conductive loop 3 can be controlled by a change in capacitance in the loop 3. Therefore in an embodiment of the einvention, the conductive loop 3 of the antenna element 2 comprises a circuit for changing the capacitance 13 in the loop 3. In a further embodiment the amplitude of the current in the conductive loop 3 can be controlled by adaptation of the energy harvesting unit 6 designed to put an effective real impedance in the loop 3 that is associated with the electrical energy storage into the electric energy storage device 7. The driving RF field comes from the body coil, which has been designed for low power square pulses. The low power of the body coil eases design constraints for arcing and high voltage components. The local coil has the capability to greatly enhance local RF field due to size and Q-factor and thus enable the appropriate flip angles. Previous tests suggest that a 1.5T knee coil could operate on 1% of the power the body coil would require. The current in each loop can also easily be monitored in a variety of ways, and used for safety, SAR monitoring and image reconstruction via detailed RF field patterns.

With local receiver 9 and control unit 8, the device can be associated with a wireless data communication system 12 for data output. The result is a local transmit receive coil with built-in safety, no RF cables, self-powering and potentially system agnostic. Full capability is possible under RF-only encoding schemes, which might be appropriate for lower field systems, but also could be used with gradient encoding and take advantage of Transmit SENSE, reduced artefact outside of the region of interest and low RF system costs.

Further, in one embodiment, a control signal path 16 is provided between the electronic components, for example, the preamplifier 10, processor 11, receiver 9 and the antenna element 3 that tells the impedance control unit 4 and/or the energy harvesting unit 6 what do to and when to do it, based on demands from a memory or a communication from the control unit 8 and using the pick-up loop 5 knowledge of the RF pulse being transmitted.

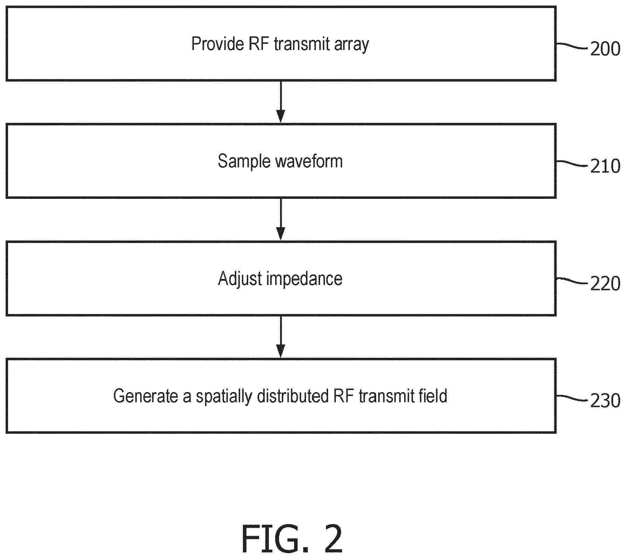

Fig. 2 shows a flowchart of a method for operating a magnetic resonance imaging system for acquiring magnetic resonance data. The method starts with step 200 by providing an RF transmit array 1 comprising a least one antenna element 2, the antenna element 2 comprising a conductive loop 3, wherein the antenna element 2 is adapted to be driven by a radio frequency (RF) driving field, each antenna element 2 comprising an impedance control unit 4 for controlling the impedance of the antenna element 2, each antenna element 2 further comprising at least one pick-up loop 5 for sampling RF pulses to control a transmit/receive switching of the antenna element 2 and allowing impedance selection for each antenna element 2, wherein the RF transmit array 1 is arranged to generate a spatially distributed RF transmit field for RF spatial encoding of magnetic resonance signals by dynamically controling the impedance of the antenna element 2. Next in step 210 a waveform of the RF driving field is sampled by the pick-up loop 5. In step 210 the impedance of the antenna element 2 is adjusted. In an embodiment of the invention the step of adjusting the impedance of the antenna element 2 comprises the step of adjusting the phase and amplitude of the RF current in the conductive loop 3 of the antenna element 2. Finally in step 220 a spatially distributed RF transmit field for inducing RF spatial encoding in magnetic resonnace signals is generated. In a further embodiment of the invention each antenna element 2 comprises an energy harvesting unit 6 and the method comprises the following additional steps of transfering excess electrical current in the conducive loop 3 of the antenna element 2 to an electric energy storage device 7 and providing the energy stored in the electrical storage device 7 for power supply of electronic components of the RF transmit array 1.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| RF transmit array | 1 |
| antenna element | 2 |
| conductive loop | 3 |
| impedance control unit | 4 |
| pick-up loop | 5 |
| energy harvesting unit | 6 |
| electric energy storage device | 7 |
| control unit | 8 |
| receiver | 9 |
| preamplifier | 10 |
| processor | 11 |
| wireless data communication system | 12 |
| circuit for changing capacitance | 13 |
| current path to electric energy storage device | 14 |
| current path to electronics | 15 |
| control signal path | 16 |

## Claims

1. A radio frequency (RF) transmit array (1) for magnetic resonance imaging, the RF transmit array (1) being arranged to generate an RF transmit field, the RF transmit array (1) comprising:
- a least one antenna element (2), the antenna element (2) comprising a conductive loop (3), wherein the antenna element (2) is adapted to be driven by a radio frequency (RF) driving field,
- each antenna element (2) comprising an impedance control unit (4) for controlling the impedance of the antenna element (2),
- each antenna element (2) further comprising at least one pick-up loop (5) for sampling RF pulses to control a transmit/receive switching of the antenna element (2) and allowing impedance selection for each antenna element (2),
- wherein the RF transmit array (1) is arranged to generate a spatially distributed RF transmit field for RF spatial encoding of magnetic resonance signals by dynamically controling the impedance of the antenna element (2).

2. The RF transmit array according to claim 1, wherein the impedance control unit (4) is further configured to adjust the impedance of the antenna element (2) on the basis of the RF driving field and/or based on instructions contained in a control unit (8) and/or instructions communicated to the control unit (8) from an external source.

3. The RF transmit array according to one of the preceeding claims, wherein each antenna element (2) comprises an energy harvesting unit (6), wherein the energy harvesting unit (6) is configured for transfering excess electrical current in the conductive loop (3) of the antenna element (2) to an electric energy storage device (7).

4. The RF transmit array according to claim 3, wherein energy harvesting unit (6) is further configured to control an amplitude of an RF current in the conductive loop (3) of the antenna element (2).

5. The RF transmit array according to claims 3 or 4, wherein the electric energy storage device (7) is a battery, an accumulator or a capacitor.

6. The RF transmit array according to one of the preceeding claims, wherein the antenna element (2) comprises a control unit (8) for controlling the transmit/receive switching of the antenna element (2).

7. The RF transmit array according to claim 6, wherein the control unit (8) comprises a wireless data communication system (12).

8. The RF transmit array according to one of the preceeding claims, wherein the conductive loop (3) of the antenna element (2) comprises a circuit for changing the capacitance (13) in the conductive loop (3) for controlling the phase of the RF current in the conductive loop (3).

9. A magnetic resonance imaging system for acquiring magnetic resonance data, wherein the magnetic resonance imaging system comprises:
an RF transmit array (1) according to one of the claims 1 to 8.

10. The magnetic resonance imaging system according to claim 9, wherein the MR imaging system comprises a body coil for generating the RF driving field.

11. A method for operating a magnetic resonance imaging system for acquiring magnetic resonance data, wherein the method comprises the following steps:
- providing an RF transmit array (1) acoording to one of the claims 1 to 8,
- sampling a waveform of the RF driving field by the pick-up loop (5),
- adjusting the impedance of the antenna element (2),
- generating a spatially distributed RF transmit field for inducing RF spatial encoding in magnetic resonance signals.

12. The method according to claim 11, wherein the step of adjusting the impedance of the antenna element (2) comprises the step of adjusting the phase and amplitude of the RF current in the conductive loop (3) of the antenna element (2).

13. The method according to claim 12, wherein each antenna element (2) comprises an energy harvesting unit(6) and the method comprises the following additional steps:
- transfering excess electrical current in the conducive loop (3) of the antenna element (2) to an electric energy storage device (7),
- providing the energy stored in the electrical storage device (7) for power supply of electronic components of the RF transmit array (1).

14. A computer program product comprising machine executable instructions, wherein the machine executable instructions are for execution by a processor controlling a magnetic resonance imaging system for acquiring magnetic resonance data, according to one of the method claims 11 to 13.

15. A radio-frequency antenna configured for acquiring magnetic resonance data, wherein the radio-frequency antenna comprises:
- a least one antenna element, the antenna element comprising a conductive loop, wherein the antenna element is adapted to be driven by a radio frequency (RF) driving field,
- each antenna element comprising an impedance control unit for controlling the impedance of the antenna element,
- each antenna element further comprising at least one pick-up loop wherein the pick-up loop is configured to sample RF pulses to control TR switching and allowing impedance selection for each antenna element for generating a spatially distributed RF transmit field for RF spatial encoding of magnetic resonance signals by dynamically controling the impedance of the antenna element (2).
